# FASCICULE DE BREVET EUROPEEN

(11) **EP 2 137 799 B1**
(45) Date de publication et mention de la délivrance du brevet: **11.05.2016**
(21) Numéro de dépôt: 08799834.0
(22) Date de dépôt: 18.03.2008
(51) Int. Cl.: H02B 1/30, H05K 5/02, H01H 71/02, H01H 71/00

(54) **BOITIER AVEC SUPPORT INFORMATIQUE REENREGISTRABLE POUR FIXATION DANS UNE ARMOIRE TECHNIQUE**
GEHÄUSE MIT EINEM MEHRMALS BESPIELBAREN COMPUTERMEDIUM ZUR BEFESTIGUNG IN EINEM SCHALTSCHRANK
CASING COMPRISING A RE-RECORDABLE COMPUTER MEDIUM TO BE FIXED IN A SERVICE CABINET

(30) Priorité: 23.03.2007 FR 0702145; 24.10.2007 FR 0707446
(43) Date de publication de la demande: 30.12.2009
(73) Titulaire: Keter Technologies Europe, 75017 Paris (FR)
(72) Inventeur: HANIA, Binhas, Régis, F-94700 Maisons Alfort (FR)
(74) Mandataire: Schmidt, Martin Peter
(86) Numéro de dépôt international: PCT/FR2008/000353
(87) Numéro de publication internationale: WO 2008/129179

(56) Documents cités:
- DE-A1-102004 037 735
- DE-U1-202005 009 123
- DE-U1-202006 011 236
- DE-U1-202007 001 543
- DE-U1-202007 004 904
- FR-A- 2 503 527
- FR-A- 2 689 332
- FR-A1- 2 620 895
- US-A- 4 958 252
- US-A- 5 923 531
- US-A- 6 011 701
- US-A1- 2005 110 481
- US-B1- 6 552 916
- US-B1- 6 854 984

## Description

### Domaine technique de l'invention

Cette invention concerne un boitier ou compartiment contenant un support informatique réenregistrable, tel qu'une mémoire flash, et pourvu d'une protection antimagnétique et / ou anti-électrostatique, ledit boitier pouvant être fixé dans un coffret ou une armoire technique et notamment un coffret ou une armoire électrique, afin de stocker des informations techniques concernant l'installation desservie par ladite armoire technique.

### Etat de la technique

Les personnes qui interviennent dans les coffrets ou armoires (ces deux termes étant utilisés ici indifféremment) techniques pour réparer, dépanner ou modifier les composants et équipements présents dans ce coffret ou armoire technique ou dans l'installation desservie par l'armoire technique doivent disposer des informations techniques nécessaires concernant l'équipement de l'armoire, les composants utilisés et leur agencement, et doivent disposer aussi des schémas qui décrivent l'installation technique desservie par ladite armoire, afin que cette intervention puisse être effectuée de manière efficace, rapide, conformément aux normes techniques applicables, et dans des bonnes conditions de sécurité. Dans le cas des armoires électriques ou armoires de distribution, ces informations techniques comprennent notamment les schémas électriques des circuits desservies par ladite armoire, et le descriptif précis des composants électroniques et électrotechniques : contacteurs, disjoncteurs, disjoncteurs différentiels, porte-fusibles, fusibles, délesteurs etc. Dans le cas d'installations de gaz, ces informations concernent l'identification des conduits, leur débit,leur pression, la nature et pureté des gaz etc.

Selon l'état de la technique, ces informations techniques, par exemple les schémas électriques ou schémas de montage, se présentent typiquement sous la forme de documents sur support papier, qui peuvent être écrits, dessinés ou imprimés, sur des feuilles isolées ou reliées, et pour des installations de complexité importante, sous la forme manuels techniques. L'ensemble de ces documents est appelé ici la « documentation technique ». Cette documentation technique peut comprendre un ou plusieurs fascicules, cahiers, reliures ou manuels. Elle est habituellement stockée dans un compartiment en tôle ou en plastique qui est aménagé à l'intérieur de la porte de ladite armoire. Un tel dispositif est décrit par exemple dans la demande de brevet DE 2 503 527 (Rittal Werke). Des documents compor-tant un faible nombre de feuilles peuvent aussi être positionnés dans une pochette transparente en plastique fixée à l'intérieur de la porte ou à un autre endroit approprié à l'intérieur ou à l'extérieur de l'armoire technique.

Il est important que cette documentation technique reste disponible et lisible pendant toute la durée d'utilisation de ladite installation, car il est difficile, long et dangereux d'intervenir sur une installation dont on ne connaît pas le schéma et le descriptif technique des composants. Même si une copie de cette documentation technique doit exister quelque part, chez l'installateur historique ou chez le propriétaire du bâtiment où se trouve l'installation, la disponibilité immédiate de la documentation technique dans l'armoire technique même, ou à proximité de celle-ci est indispensable, et cela pas seulement pour des interventions urgentes.
La perte de la documentation technique peut avoir plusieurs causes : l'installateur qui intervient sur l'installation peut oublier de la remettre à sa place, ou une personne non habilitée à intervenir sur l'armoire peut l'enlever, pour quelque motif que ce soit. Par ailleurs, même si la documentation technique est remise à sa place après consultation, son support papier peut ne pas être durable : il peut absorber de l'humidité et de la poussière, il peut être rongé par des souris ou des insectes, il peut être sali ou abîmé lors de sa consultation. Au cours des années voire décennies, la documentation technique peut ainsi devenir illisible.

Ce problème peut être exacerbé dans le cas d'armoires techniques en milieu industriel, où la poussière, les émanations gazeuses, l'humidité, les écarts de température, les vibrations et d'autres influences extérieures peuvent conduire au vieillissement accéléré du support papier de la documentation technique. Par ailleurs c'est en milieu industriel où cette documentation technique risque d'être consultée plus souvent qu'en milieu résidentiel, et où les interventions sur l'installation technique desservie par l'armoire technique sont particulièrement urgentes.

### Problèmes à résoudre

Le problème que la présente invention cherche à résoudre est de présenter un mode de stockage durable pour la documentation technique d'une armoire technique, qui évite le support papier, évitant ainsi la perte ou le vol de la documentation, et qui est facile d'utilisation pour le personnel qualifié habilité à intervenir sur l'armoire technique.

Un autre problème est celui de la mise à jour de la documentation technique en cas de modification de l'installation. La documentation sur papier ne peut être modifiée que par le remplacement des feuilles qui la constituent, ou par des annotations apportées sur lesdites feuilles. La première option suppose que le technicien dispose du fichier informatique qui contient le contenu de ladite documentation, ainsi que d'un moyen d'impression. La seconde option peut conduire à des inscriptions peu lisibles ou peu durables, et dans le cas de schémas complexes, ou de modifications successives, ces schémas modifiés risquent de devenir progressivement illisibles.

### Objet de l'invention

Un premier objet de la présente invention est un boitier **1** pour la sauvegarde d'informations techniques par un utilisateur, ledit boitier étant destiné à être fixé dans une armoire technique, et notamment destiné à être fixé sur un rail métallique **6,** ledit boitier **1** comprenant une ouverture frontale qui peut être fermée par un moyen de fermeture **3,** tel qu'un couvercle ou un capot, et comprenant en outre des moyens de fixation **5** permettant de fixer ledit boitier **1** dans ladite armoire technique, et avantageusement sur ledit rail métallique **6,** et ledit boitier **1** étant caractérisé en qu'il comprend en outre
(a) au moins un moyen de protection antimagnétique et / ou antistatique **4,** et
(b) un support réenregistrable **2, 21** de stockage de données informatiques, ledit support de stockage **2, 21** étant une mémoire de type clef USB comportant une prise USB **7,** fixée dans le boitier **1** ou dans son moyen de fermeture **3,** de manière à ce que sa prise USB soit accessible après l'ouverture dudit moyen de fermeture, et étant protégé par ledit moyen de protection antimagnétique et/ou antistatique **4.**

Un autre objet de la présente invention est l'utilisation dudit support informatique **2, 21** contenu dans un boitier **1** selon l'invention pour la sauvegarde des plans ou informations techniques décrivant l'installation relevant de l'armoire technique dans laquelle ledit boitier est installé.

Encore un autre objet de la présente invention est un procédé de mise à jour d'informations techniques décrivant l'installation technique relevant d'une armoire technique dans laquelle est installé un boitier **1** selon l'invention, ledit procédé comprenant les étapes suivantes :
(i) on ouvre ledit moyen de fermeture **3,**
(ii) on branche une première prise **8** d'un câble **9** relié ou à relier par une seconde prise **10** à un ordinateur sur la prise **7** de ladite clef USB **21,**
(iii) on transfère des informations de l'ordinateur vers ledit support réenregistrable **2** et notamment vers ladite clef USB **21** et / ou on transfère des informations dudit support réenregistrable **2** et notamment de ladite clef USB **21** vers ledit ordinateur,
(iv) on débranche ladite première prise **8** du câble **9** de la prise **7** dudit support réenregistrable **2** et notamment de ladite clef USB **21,**
(v) on referme ledit moyen de fermeture **3.**

### Description des figures

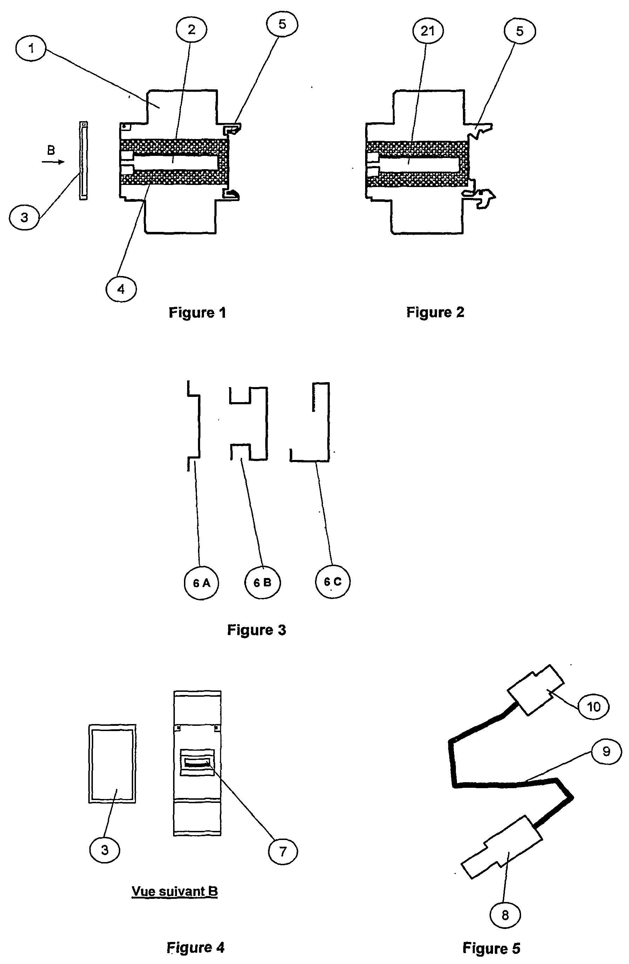

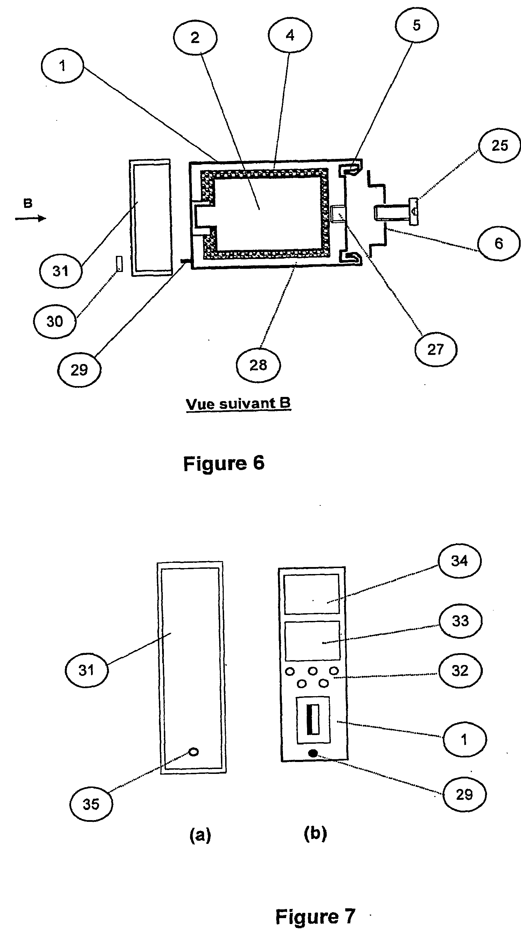

Les figures 1 à 4, 6 et 7 illustrent des modes de réalisation de la présente invention.
La figure 1 montre une coupe d'un boitier 1 selon l'invention.
La figure 2 montre une coupe d'un autre boitier **1** selon l'invention, qui présente des pattes de fixation **5** de forme différente.
La figure 3 montre trois types de rails **6A,6B,6C** selon l'état de la technique sur lesquels le boitier **1** selon l'invention peut être monté.
La figure 4 montre une vue frontale (vue suivant B comme indiqué sur la figure 1) d'un boitier **1** selon l'invention.
La figure 5 montre un câble **9** de type courant permettant de relier la clef USB **21** à un ordinateur portable, en utilisant deux prises **8,10**.
La figure 6 montre une coupe d'un autre boitier **1** selon l'invention. On note la présence d'un boulon de blocage arrière **25** qui coopère avec le trou fileté **27** dans le boitier, susceptible de fixer fermement le boitier **1** sur le rail **6.**
La figure 7b montre une vue frontale (vue suivant B comme indiqué sur la figure 1 ou 6) d'un boitier 1 selon un mode de réalisation particulier, qui comporte un écran d'affichage **34,** un clavier **33** et des LEDs **32.** Ce boitier peut comporter (figure 7a) un capot de protection **31.**

Les repères suivants sont utilisés :

| | |
|---|---|
| Boitier | 1 |
| Support informatique réenregistrable | 2 |
| Couvercle de protection | 3 |
| Dispositif de protection antimagnétique et/ou antistatique | 4 |
| Moyens de fixation | 5 |
| Rail de fixation | 6, 6A, 6B, 6C |
| Prise de la clef USB | 7 |
| Prise pour clef USB | 8 |
| Câble de liaison | 9 |
| Prise pour sortie USB de l'ordinateur | 10 |
| Clef mémoire USB | 21 |
| Boulon de blocage arrière | 25 |
| Filetage permettant de bloquer le boulon de blocage arrière sur le rail de fixation | 27 |
| Résine en polymère | 28 |
| Vis de blocage avant | 29 |
| Moyen de blocage avant plombable | 30 |
| Capot de protection | 31 |
| Moyen d'affichage (LEDs) | 32 |
| Clavier | 33 |
| Moyen d'affichage (écran) | 34 |
| Trou de passage du moyen de blocage avant | 35 |

### Description détaillée de l'invention

Le problème est résolu selon l'invention par un boitier doté de moyens de protection antistatique et / ou antimagnétique **4,** qui peut être installé sur les rails normalisés **6,6A,6B,6C** sur lesquels sont installés habituellement les boitiers contenant des composants électriques dans une armoire électrique ou dans un tableau électrique. Le boitier **1** selon l'invention comprend un support informatique **2** fixe ou amovible, de préférence réenregistrable, tel qu'une mémoire de type flash, qui est une mémoire de type clef USB **21.** Ce support informatique peut contenir un ou plusieurs fichiers informatiques qui contiennent la documentation technique de l'installation technique desservie par l'armoire.

Le boitier **1** selon l'invention peut avoir la même forme extérieure (i.e. hauteur, largeur, profondeur, éventuellement contours de la face avant) qu'un boitier standardisé utilisé pour contenir des composants électrotechniques. Ce mode de réalisation est préféré, car pour la fabrication du boitier **1** selon l'invention, on peut ainsi utiliser les moules qui servent à la fabrication de boitiers standards, sachant que le prix d'un moule destiné à la mise en forme de matières plastiques est un facteur de coût important pour le fabricant desdits boitiers.

Ainsi le boitier **1** selon l'invention peut être un boitier qui a la même forme extérieure qu'un boitier standard utilisé par exemple pour un coupe-circuit, un porte-fusible, un sectionneur, un interrupteur (tel qu'un interrupteur sectionneur ou un interrupteur différentiel), un contacteur (tel qu'un contacteur jour/nuit), un discontacteur, un disjoncteur (tel qu'un disjoncteur sectionneur ou un disjoncteur différentiel), un télérupteur, un relais, un automate, un variateur, un contact de début et/ou fin de course, une minuterie, un système d'éclairage, ou il peut s'agir d'un boitier contenant un dispositif sélectionné dans le groupe constitué par : un coupe-circuit, un porte-fusible, un sectionneur, un interrupteur, un interrupteur sectionneur, un interrupteur différentiel, un contacteur, un contacteur jour/nuit, un discontacteur, un disjoncteur, un disjoncteur sectionneur, un disjoncteur différentiel, un télérupteur, un relais, un automate, un variateur, un contact de début et/ou fin de course, une minuterie, un système d'éclairage, une horloge, un système de programmation horaire, un voyant lumineux, un bouton poussoir, un commutateur à simple ou plusieurs positions. En effet, dans un mode de réalisation particulier de la présente invention, on intègre le support réenregistrable de stockage de données informatiques **2, 21** dans un boitier de type courant qui contient déjà un des composants électrotechniques cités, à condition qu'il y ait suffisamment d'espace pour ledit support réenregistrable de stockage de données informatiques **2, 21** et son moyen de protection antimagnétique et / ou antistatique et / ou antiélectromagnétique **4,** et à condition que ledit boitier dispose d'un moyen de fermeture **3** qui permet un accès aisé audit support **2, 21.** De tels boitiers standard sont décrits par exemple dans le modèle d'utilité allemand DE 20 2005 009 123 U1 (Dehn + Söhne GmbH + Co.) et dans la demande de brevet français FR 2 689 332 (General Electric Company).

Un boitier **1** selon l'invention possède typiquement deux faces latérales parallèles et plates, et une face arrière perpendiculaire aux deux faces latérales, ladite face arrière pouvant comporter les moyens de fixation permettant de fixer le boitier **1** sur un rail métallique **6** de type normalisé. Le boitier **1** selon l'invention comprend un moyen de fermeture **3,** tel qu'un couvercle ou capot, qui est soit totalement amovible, soit qui peut être rabattu ou ouvert tout en restant fixé au boitier. Dans un mode de réalisation, le boitier **1** selon l'invention est un boitier de coupe-circuit de modèle courant, avec une ouverture pivotante. Dans d'autres modes de réalisation, le boitier **1** a la forme d'un cube ou d'un parallélépipède, le moyen de fermeture **3** étant un couvercle fixé par un côté horizontal ou par un côté vertical.

Avantageusement, le moyen de fermeture **3**, et notamment le couvercle ou capot, se trouve sur la face avant du boitier **1** tel qu'elle apparaît à l'utilisateur lorsque le boitier **1** est monté sur le rail **6**. Le moyen de fermeture **3** peut être fixé sur le boitier **1** par tout moyen approprié, par exemple par encliquetage. Il peut être protégé par plombage (à l'aide d'un moyen de plombage **29,** qui peut être une vis plombable) ou par une serrure à clef ou tout autre moyen de protection. Il peut être transparent ou opaque.

Le boitier **1** selon l'invention peut être pourvu d'une protection spécifique ou supplémentaire contre la poussière et / ou l'humidité, telle qu'un volet, de préférence transparent, qui recouvre au moins la face avant dudit boitier, et qui comprend avantageusement un joint élastique.

Le boitier **1** selon l'invention peut avantageusement comporter un trou fileté **27** sur l'arrière qui coopère avec un boulon de blocage **25** introduit par l'arrière à travers un trou aménagé dans le rail **6.** Ainsi on empêche que le boitier ne puisse être retiré du rail sans dévisser, préalablement et par l'arrière du rail, le boulon de déblocage ; c'est une fonction anti-vol.

Le boitier **1** peut être fabriqué en tout matériau acceptable pour l'application visée, par exemple en résine polymère **28 ;** il doit être conforme à la règlementation et aux normes applicables, que l'homme du métier connaît bien, et notamment à la règlementation concernant les Etablissements Recevant du Public (ERP) et les Immeubles de Grande Hauteur (IGH). A ce titre, il doit être conforme à la norme NF EN 60 695-2-11, et doit répondre aux normes concernant l'auto-extinguibilité (essai de tenue au fil incandescent à 750°C). Des matériaux acceptables sont notamment : le caoutchouc naturel, le caoutchouc d'éthylène propylène (EPR), le polychlorure de vinyle (PVC), le polyéthylène réticulé (PR), le polychloroprène (PCP), le polyamide. Avantageusement, le boîtier est conçu et réalisé de manière à résister également à l'essai de pénétration de corps solides et liquides, tel que spécifié par la norme NF EN 60 529 (classe IP 65 ou meilleur), et aux impacts mécaniques, tel que spécifié par la norme NF EN 50 102 (classe IK 09 ou meilleur). Dans un mode de réalisation, on utilise une résine polymère composite, qui peut contenir des charges conductrices.

Le boitier **1** comprend des moyens de fixation 5, tels que des pattes et/ou rails de fixation, qui coopèrent avec le rail **6,6A,6B,6C** de fixation métallique sur lequel lesdits moyens de fixation **5** sont destinés à être fixés, et qui équipe habituellement les armoires et coffrets électriques. Ce rail **6** est habituellement un rail profilé en aluminium ou en acier. Des modes de fixation du boitier **1** selon l'invention sont notamment : l'encliquetage sur un rail métallique à l'aide de deux fixations clipsables, l'encliquetage sur un profile de type chapeau ou un profilé asymétrique ou un profilé combiné, le montage sur un montant perforé en U, l'encliquetage sur barreau symétrique, le montage ou encliquetage sur grille perforée, le montage sur châssis, le montage sur platine pleine (perforée pour armoire ou perforée pour coffret), le montage sur embase magnétique, le montage et fixation direct en saillie, le montage dans une boîte d'adaptation pour montage en saillie, le montage sur la face avant d'une armoire technique, le montage hors du tableau électrique à l'extérieur sous abris.
Tous ces modes de réalisation ne font pas intervenir un rail 6, et les moyens de fixation **5** peuvent être des moyens qui ne coopèrent pas avec un rail **6**.
Le boitier **1** selon l'invention comprend des moyens de protection antimagnétique et / ou antistatique et/ou anti-électromagnétique **4,** qui entourent au moins partiellement le support informatique réenregistrable **2,21.** Cette protection est obligatoire si le boitier **1** est destiné à être utilisé dans des armoires dans lesquelles circulent des forts courants électriques, de l'ordre de 10 A ou plus, mais il est prudent de l'utiliser en tous les cas, pour tout environnement, afin de garantir l'intégrité des données informatiques sur une longue durée. On connaît des disjoncteurs électriques comportant des mémoires de type EEPROM sans aucune protection contre les parasites électromagnétiques (voir le brevet US 4,958,252).
Les moyens de protection antimagnétique et / ou antistatique **4** utilisés dans le boitier selon l'invention peuvent prendre différentes formes. A titre d'exemple, le boitier **1** peut être fabriqué en matière antistatique et antimagnétique, ou comprendre un dispositif de protection antistatique et antimagnétique. Dans certains cas, il peut suffire de prévoir uniquement une paroi métallique de dimension significative.
Dans un premier mode de réalisation, le boitier **1** selon l'invention, s'il est prévu pour être utilisé dans une armoire électrique, est avantageusement en matériau conducteur, et plus particulièrement en matériau antimagnétique et / ou antistatique. Ce matériau antimagnétique et / ou antistatique peut constituer la masse du matériau du boitier, ou le boitier peut comporter un revêtement antimagnétique, ledit revêtement antimagnétique pouvant se trouver sur les surfaces externes ou sur les surfaces internes dudit boitier, ou sur les deux à la fois, ou sur une partie seulement desdites surfaces. Dans un mode de réalisation, on utilise une résine polymère composite contenant des charges conductrices.

Dans un autre mode de réalisation, le boitier **1** selon l'invention peut contenir un dispositif de protection antimagnétique et / ou antistatique, tel qu'une petite boîte en métal, ou une enveloppe faisant effet de cage de Faraday en treillis métallique, en fil métallique, ou en plastique pourvu d'un revêtement conducteur d'épaisseur et de conductivité suffisantes.
On peut également fixer le support informatique réenregistrable **2, 21** dans le boitier à l'aide d'une colle ou pâte chargée de particules conductrices qui entoure au moins partiellement ledit support informatique.

Ces différents modes de réalisation peuvent aussi être combinés.

Le support informatique particulièrement préféré dans le cadre de la présente invention est une mémoire flash, par exemple une mémoire de type RAM (Random Access Memory) ou une mémoire de type RWM (Read-Write Memory), ou encore une mémoire de type EEPROM (Electrically Erasable Programmable Read Only Memory). Selon l'invention on utilise le dispositif connu sous la dénomination « clef USB » **21**. Dans cette dénomination, USB signifie Universal Sérial Bus, une technologie de connexion qui simplifie la liaison des périphériques, et qui est particulièrement adaptée aux périphériques lents. La clef USB dispose de nombreux avantages, surtout si la technologie dite « hot-plug » est adoptée : elle peut être configurée de manière à être reconnue automatiquement par le système d'exploitation de l'ordinateur qui doit la lire (fonction dite « Plug & Play), elle peut être déconnecté « à chaud », c'est-à-dire sans éteindre l'ordinateur, et elle n'a pas besoin d'une alimentation auxiliaire, le courant électrique étant fourni par le bus USB de l'ordinateur. Par ailleurs, la clef USB est un support informatique réenregistrable, c'est-à-dire on peut facilement modifier les informations stockées, ou y ajouter d'autres. Une clef USB comporte une prise USB **7** par laquelle elle peut être reliée, par l'intermédiaire d'un câble de liaison **9** pourvu d'une prise **8** qui coopère avec celle **7** de la clef USB, à un ordinateur.

Dans un mode de réalisation avantageux, la mémoire flash, et notamment la clef USB **21** est fixée dans le boitier 1 de manière permanente. La mémoire flash et notamment la clef USB **21** peut être fixée dans le boitier **1** ou dans le moyen de fermeture **3** (par exemple dans le couvercle) par tout moyen approprié, par exemple par collage, ou par injection autour de la clef de matière plastique ou d'un composant similaire. La prise USB **7** doit rester accessible après l'ouverture dudit moyen de fermeture **3,** de manière à pouvoir brancher un câble sur ladite prise **7**.

Dans un autre mode de réalisation, le boitier **1** comporte une mémoire de type ROM (Read-Only Memory), programmée ou utilisée de manière à permettre l'empilement d'informations nouvelles, sans pouvoir effacer les anciennes.

Dans encore un autre mode de réalisation, le boitier **1** comporte une pluralité de supporte informatiques de type différent, par exemple une mémoire flash et une mémoire de type ROM. Cette mémoire ROM peut être utilisée ou programmée de manière à permettre l'èmpilement d'informations nouvelles, sans pouvoir effacer les anciennes.

Dans un mode de réalisation avantageux, le boitier **1** selon l'invention comporte également un moyen de télétransmission des données informatiques stockées sur le support informatique réenregistrable. Ce moyen de télétransmission doit être apte à transmettre des données du support réenregistrable **2, 21** vers un utilisateur. Il doit comporter une source d'énergie, typiquement une pille électrique, ou une alimentation électrique, par exemple de type 220 V ou 48 V ou 24. Ledit moyen de télétransmission peut être par exemple un moyen de télétransmission optique, en particulier par faisceau infrarouge, ou un moyen de télétransmission par ondes hertziennes. Dans le cas d'un moyen de télétransmission par d'ondes Hertziennes, ce moyen comprend avantageusement une antenne. Cette antenne peut par exemple être sérigraphiée ou imprimée sur la surface externe ou interne du boitier 1. En plus, ou alternativement, le boitier **1** peut comprendre une connectique appropriée pour le branchement sur un réseau informatique.

Le boitier **1** selon l'invention peut être installé dans tout type d'armoire technique, existants ou nouvellement installés, situé dans des locaux d'habitation, des maisons individuelles, des appartements, des locaux industriels, des locaux commerciaux, des hôpitaux, des entrepôts, des locaux techniques, des salles informatiques, des établissements recevant du public, des immeubles de grande hauteur, des usines, ou encore à l'extérieur, par exemple dans des coffrets électriques de chantier. Le boitier selon l'invention peut aussi être installé dans les armoires techniques embarqués, c'est-à-dire à bord de trains, avions, bateaux, groupes électrogènes mobiles, engins agricoles motorisés, véhicules et dispositifs militaires (tels que : chars, tanks, sous-marins), voitures de tourisme, véhicules utilitaires.
Le boitier **1** selon l'invention peut également être installé dans des feux de signalisation routière, des bornes (telles que des bornes d'information ou des bornes de signalisation routière), des poteaux (tels que des poteaux de signalisation ou des poteaux de feux de signalisation routière), des horodateurs (tels que des horodateurs électroniques), des machines de vente. Il peut également être installé au niveau d'un tableau de bord de véhicules utilitaires, véhicules de tourisme, d'engins agricoles, de véhicules militaires (tanks, chars, véhicules de transport de troupes).
C'est en particulier (mais pas exclusivement) dans ce cas de l'incorporation dans un tableau de bord de véhicule tel qu'énuméré ci-dessus que le boitier **1** n'est pas forcément fixé sur un rail métallique **6,** mais peut comporter des moyens de fixation **5** permettant un autre mode de fixation, tels que le collage, l'encliquetage, le clipsage. Dans un mode de réalisation particulier, le boitier comporte d'une part une mémoire ROM avec une connectique de type USB reliée au calculateur du véhicule par une connectique spécifique qui peut être une connectique de type CAN, et d'autre part, une mémoire flash avec une connectique de type USB. Dans la mémoire ROM, le technicien de maintenance (garagiste) rentre les informations relatives à l'entretien, telles que les gammes de maintenance du véhicule, alors que les informations relatives à la date et l'heure de l'entretien sont automatiquement rentrées par la liaison du module mémoire ROM au calculateur de la voiture ou du véhicule. De même, le calculateur de bord du véhicule pourra enregistrer les kilomètres parcourus, par exemple chaque millier ou chaque centaine de kilomètres. Il ne pourra pas y avoir donc de triche lors de la revente du véhicule, car les informations rentrées dans la mémoire ROM ne pourront plus être modifiées sans la détruire. Dans ce mode de réalisation, la mémoire de type flash peut contenir par exemple la documentation de la voiture, le livret d'entretien, les feuilles de calculs de suivi du kilométrage, divers matériel d'informations ; ces informations peuvent être mises à jour par le technicien de maintenance ou par l'utilisateur du véhicule.

Dans un mode de réalisation particulier, le boitier **1** selon l'invention peut contenir une pluralité de supports informatiques réenregistrables **2.** Il est également possible d'installer une pluralité de boitiers **1** selon l'invention dans une même armoire technique, de préférence à des endroits différents, exposés de manière différente aux champs électriques et / ou magnétiques éventuellement présents dans l'armoire technique. Ainsi, on peut garder une copie supplémentaire des fichiers.

L'utilisation d'une clé USB **21** comme support informatique réenregistrable **2** est particulièrement avantageuse. Ainsi, le boitier **1** selon l'invention est compatible avec tous les ordinateurs équipés d'un port USB et d'un module lecteur flash USB de type Plug and Play. Avantageusement, on utilise une prise USB à 4 broches de type A et une interface compatible avec les systèmes 1 x Hi-speed USB 2.0 et USB 1.1. Avantageusement, le support informatique réenregistrable est compatible avec les systèmes d'exploitation Windows^{®} Vista/XP/2000/ME.

Le taux de transfert en lecture est avantageusement d'au moins 18 Mo/s, le taux de transfert en écriture avantageusement d'au moins 11,5 Mo/s.
La capacité de la mémoire flash de la clé USB **21** est typiquement compris entre 256 Mo et 4096 Mo, et avantageusement d'au moins 1 GO. Un tel support informatique réenregistrable **2** offre, parmi les technologies existantes, un nombre de cycles écriture/lecture maximal. Dans un mode de réalisation, on partitionne l'espace mémoire du support informatique réenregistrable **2** avec un mot de passe utilisateur. On peut aussi protéger tout le support informatique **2** par au moins un mot de passe, que l'utilisateur doit renseigner pour que la connexion puisse être établie.
Dans un mode de réalisation avantageux, le support informatique réenregistrable **2** est configuré de manière à comprendre aux moins deux modes d'accès différents :
Un premier mode d'accès permet à l'utilisateur uniquement de lire les données contenues dans ce support informatique **21.** Un mot de passe est optionnel pour ce premier mode d'accès. Un deuxième mode d'accès permet à l'utilisateur de lire et d'écrire les données contenues dans ce support informatique **21.** Pour accéder à ce mode d'accès, un mot de passe est obligatoire. L'accès au support informatique **21** peut se faire par l'intermédiaire d'une connexion réseau, par exemple via une prise réseau, qui peut être de type RJ45. Cette prise réseau se situe avantageusement sur la face avant du boitier **1**. La connexion au réseau informatique peut aussi être une connexion sans fil, par l'intermédiaire d'un moyen de télétransmission.
On peut prévoir un troisième mode d'accès, réservé au constructeur du modèle ou son préposé, c'est-à-dire à un utilisateur spécialement habilité, visant à faciliter la maintenance informatique et permettant d'accéder à l'ensemble des données sans connaître le deux mots de passes indiqués ci-dessus.

Dans un mode de réalisation particulier, l'utilisateur entre le mot de passe à l'aide d'un clavier **33,** typiquement de type numérique ou alphanumérique, qui se trouve avantageusement sur la face avant du boitier **1**. Optionnellement, le boitier peut également comprendre un ou plusieurs moyens d'affichage, par exemple un écran d'affichage **34** ou un ou plusieurs indicateurs lumineux 32, typiquement des LEDs (Light Emitting Diodes). Dans ce cas, il est particulièrement avantageux de protéger au moins le clavier **33** par un capot de protection **31.** Le clavier **33** peut aussi être intégré dans l'écran d'affichage **34**, qui est alors un écran tactile.
On peut aussi connecter le support informatique réenregistrable **2** à un réseau informatique par l'intermédiaire d'une connectique approprié, tel qu'une connectique de type RJ45.
L'invention à de nombreux avantages. Le boitier **1** selon l'invention permet à l'utilisateur le stockage durable d'un support informatique réenregistrable **2,** notamment d'une mémoire flash, et plus particulièrement d'une clef USB **21.** Il peut être fixé sur les mêmes rails métalliques **6,6A,6B,6C** que les boitiers comportant des composants électriques dans les armoires électriques. Grâce au boitier **1** selon l'invention, la documentation technique de l'installation peut être facilement lue par le l'utilisateur (typiquement un technicien de maintenance) qui intervient dans l'armoire technique. L'utilisateur (technicien) peut également modifier la documentation technique, en mettant à jour le fichier informatique stocké sur le support informatique **2,** pour y incorporer les modifications qu'il vient d'effectuer sur l'installation. Il peut également stocker sur ce support 2 un compte-rendu d'intervention ou toute autre information qu'il est souhaitable de garder à la disposition des techniciens qui interviennent dans cet armoire électrique. L'utilisation d'une clé USB comme support informatique réenregistrable est particulièrement avantageux. Ses plages de fonctionnement en température (0°C à 70°C) et en taux d'hygrométrie (25 à 95%) sont particulièrement vastes, le dégagement de chaleur des composants électroniques est minimal.

### Exemple

On a réalisé un boitier selon l'invention pourvu d'une fixation à vis sur un rail normalisé, protégé contre la poussière et la projection d'eau. Le support informatique réenregistrable était une mémoire Flash de type Nand Flash Multi Level Cell, avec une capacité, selon le modèle, de 256 Mo à 4096 Mo. Une interface compatible USB 1.1, une interface de type USB 2.0 lx Hi-Speed à 4 broches type A ou une connectique spécifique compatible PDA a été utilisée. Le taux de transfert en lecture était de 18 Mo/s, le taux de transfert en écriture 11,5 Mo/s.

## Revendications

1. Boitier (1) pour la sauvegarde d'informations techniques par un utilisateur, destiné à être fixé dans une armoire technique, et notamment destiné à être fixé sur un rail métallique (6), ledit boitier comprenant une ouverture frontale et un moyen de fermeture (3) permettant de fermer ladite ouverture frontale, et ledit boitier (1) comprenant en outre des moyens de fixation (5) permettant de fixer ledit boitier (1) dans ladite armoire technique, et avantageusement sur ledit rail métallique (6),
et ledit boitier (1) étant caractérisé en qu'il comprend en outre
(a) au moins un moyen de protection antimagnétique et / ou antistatique (4), et
(b) un support réenregistrable (2, 21) de stockage de données informatiques, étant amovible ou, de préférence, fixe, et étant protégé par ledit moyen de protection antimagnétique et / ou antistatique (4) ainsi que par ledit moyen de fermeture (3), et ledit support réenregistrable de stockage de données informatiques (2) étant une mémoire de type clef USB (21) comportant une prise USE (7),
et ladite clef USB (21) étant fixée dans le boitier (1) ou dans son moyen de fermeture (3), de manière à ce que sa prise USB (7) soit accessible après l'ouverture dudit moyen de fermeture (3), de manière à pouvoir brancher un câble sur ladite prise (7).

2. Boitier (1) selon la revendication 1, dans lequel ledit moyen de fermeture (3) est un capot ou un couvercle.

3. Boitier (1) selon la revendication 1 ou 2, **caractérisé en ce qu'**il comprend en plus un moyen de télétransmission apte à transmettre des données du support réenregistrable (2, 21) vers un utilisateur, et / ou une connectique appropriée pour le branchement sur un réseau informatique.

4. Boitier (1) selon l'une quelconque des revendications 1 à 3, **caractérisé en ce que** le moyen de protection antimagnétique et / ou antistatique (4) est choisi dans le groupe constitué par :
- les revêtements conducteurs, appliqués sur au moins une partie de la surface externe ou interne, ou sur les deux à la fois dudit boitier,
- un boîtier métallique,
- un boitier en plastique revêtu d'un revêtement conducteur,
- au moins une paroi métallique,
- une cage de Faraday en fils et / ou treillis métallique,
- une colle ou pâte chargée de particules conductrices qui entoure au moins partiellement ledit support informatique.

5. Boitier (1) selon une quelconque des revendications 1 à 4, **caractérisé en ce qu'**il s'agit d'un boitier contenant un dispositif sélectionné dans le groupe constitué par :
un coupe-circuit, un porte-fusible, un sectionneur, un interrupteur, un interrupteur sectionneur, un interrupteur différentiel, un contacteur, un contacteur jour/nuit, un discontacteur, un disjoncteur, un disjoncteur sectionneur,
un disjoncteur différentiel, un télérupteur, un relais, un automate, un variateur, un contact de début et/ou fin de course, une minuterie, un système d'éclairage, une horloge, un système de programmation horaire, un voyant lumineux, un bouton poussoir, un commutateur à simple ou plusieurs positions.

6. Boitier (1) selon une quelconque des revendications 1 à 5, **caractérisé en ce qu'**il comporte en plus un clavier (33) permettant d'entrer un mot de passe, et optionnellement un ou plusieurs moyens d'affichage (32, 34).

7. Boitier (1) selon une quelconque des revendications 1 à 6, **caractérisé en ce qu'**il comprend en plus une mémoire de type ROM, utilisée ou programmée de manière à permettre l'empilement d'informations nouvelles, sans pouvoir effacer les anciennes.

8. Utilisation dudit support informatique (2, 21) contenu dans un boitier selon l'une quelconque des revendications 1 à 7 pour la sauvegarde des plans ou informations techniques décrivant l'installation technique relevant de l'armoire technique dans laquelle ledit boitier est installé.

9. Utilisation selon la revendication 8 dans une installation technique situé dans des locaux d'habitation, des maisons individuelles, des appartements, des locaux industriels, des locaux commerciaux, des hôpitaux, des entrepôts, des locaux techniques, des salles informatiques, des établissements recevant du public, des immeubles de grande hauteur, des usines, des coffrets électriques de chantier, des trains, des avions, des bateaux, des groupes électrogènes mobiles, des engins agricoles motorisés, des véhicules et dispositifs militaires, des voitures de tourisme, des véhicules utilitaires, des poteaux de signalisation, des bornes de signalisation routière, des poteaux de feux de signalisation routière, des bornes d'informations, des horodateurs ou des machines de vente.

10. Procédé de mise à jour d'informations techniques décrivant l'installation technique relevant d'une armoire technique dans laquelle est installé un boitier selon une quelconque des revendications 1 à 6, ledit procédé comprenant les étapes suivantes :
(i) on ouvre ledit moyen de fermeture (3),
(ii) on branche une première prise (8) d'un câble (9) relié ou à relier par une seconde prise (10) à un ordinateur ou un réseau informatique sur la prise (7) de ladite clef USB (21),
(iii) on transfère des informations de l'ordinateur ou du réseau informatique vers ladite clef USB (21) et / ou on transfère des informations de ladite clef USB (21) vers ledit ordinateur ou vers ledit réseau informatique,
(iv) on débranche ladite première prise (8) du câble (9) de la prise (7) de ladite clef USB (21),
(v) on referme ledit moyen de fermeture (3).

11. Procédé selon la revendication 10, dans lequel, avant le transfert d'informations entre le support enregistrable (2) et l'ordinateur ou le réseau informatique, on entre au moins un mot de passe.

## Patentansprüche

1. Gehäuse (1) für das Speichern technischer Informationen durch einen Benutzer, das dazu bestimmt ist, in einem Schaltschrank befestigt zu sein, und das insbesondere dazu bestimmt ist, auf einer metallischen Schiene (6) befestigt zu sein, wobei das Gehäuse eine Vorderseitenöffnung und ein Mittel (3) zum Verschließen umfasst, das es erlaubt, die Vorderseitenöffnung zu schließen, und wobei das Gehäuse (1) außerdem Mittel (5) zum Befestigen umfasst, die es erlauben, das Gehäuse (1) in dem Schaltschrank und vorteilhafterweise auf der metallischen Schiene (6) zu befestigen,
Gehäuse (1) **dadurch gekennzeichnet, dass** es außerdem Folgendes umfasst
(a) mindestens ein Mittel (4) zum amagnetischen und/oder antistatischen Schützen, und
(b) ein wieder beschreibbares Medium (2, 21) zum Speichern elektronischer Daten, das abnehmbar oder bevorzugt stationär ist, und das durch das amagnetische und/oder antistatische Schutzmittel (4) sowie durch das Mittel zum Verschließen (3) geschützt wird, und wobei das wieder beschreibbare Medium zum Speichern elektronischer Daten (2) ein Speicher des Typs USB-Stick (21) ist, der einen USB-Anschluss (7) umfasst, und wobei der USB-Stick (21) in dem Gehäuse (1) oder in seinem Mittel zum Verschließen (3) derart befestigt ist, dass sein USB-Anschluss (7) nach dem Öffnen des Mittels zum Verschließen (3) derart zugänglich ist, dass ein Kabel an den Anschluss (7) angeschlossen werden kann.

2. Gehäuse (1) nach Anspruch 1, wobei das Mittel zum Verschließen (3) eine Haube oder ein Deckel ist.

3. Gehäuse (1) nach Anspruch 1 oder 2, **dadurch gekennzeichnet, dass** es außerdem ein Mittel zur Fernübertragung umfasst, das geeignet ist, um Daten des wieder beschreibbaren Mediums (2, 21) zu einem Benutzer, und/oder einem Steckverbinder, der für das Anschließen an ein Rechnernetzwerk geeignet ist, zu übertragen.

4. Gehäuse (1) nach einem der Ansprüche 1 bis 3, **dadurch gekennzeichnet, dass** das amagnetische und/oder antistatische Schutzmittel (4) aus der Gruppe ausgewählt ist, die aus Folgendem besteht:
- leitende Beschichtungen, die auf mindestens einen Teil der äußeren oder inneren Oberfläche oder auf beide des Gehäuses aufgebracht sind,
- ein metallisches Gehäuse,
- ein Gehäuse aus Plastik, das mit einer leitenden Beschichtung beschichtet ist,
- mindestens eine metallische Wand,
- ein faradayscher Käfig aus Draht und/oder metallischem Geflecht,
- ein Klebstoff oder eine Paste, die mit leitenden Teilchen gefüllt ist, der/die das elektronische Datenmedium mindestens teilweise umgibt.

5. Gehäuse (1) nach einem der Ansprüche 1 bis 4, **dadurch gekennzeichnet, dass** es sich um ein Gehäuse handelt, das eine Vorrichtung enthält, die aus der Gruppe ausgewählt ist, die aus folgenden besteht: ein Abschalter, ein Sicherungshalter, ein Trennschalter, ein Ein-/Ausschalter, ein Lasttrennschalter, ein Differenzstromschalter, ein Stromwächter, ein Tag-/Nacht-Schütz, ein Überstromschalter, ein Überlastschalter, ein Leistungstrennschalter, ein Fehlerstrom-Schutzschalter, ein Stromstoßschalter, ein Relais, ein Automat, ein Dimmer, ein Anfangs- und/oder Endkontakt, ein Zeitschalter, ein Beleuchtungssystem, ein Taktgeber, ein Zeitschaltuhrsystem, eine Anzeigelampe, ein Druckknopf, ein Umschalter mit einer oder mehreren Positionen.

6. Gehäuse (1) nach einem der Ansprüche 1 bis 5, **dadurch gekennzeichnet, dass** es außerdem eine Tastatur (33) umfasst, die es erlaubt, ein Passwort einzugeben, und optional ein oder mehrere Anzeigemittel (32, 34).

7. Gehäuse (1) nach einem der Ansprüche 1 bis 6, **dadurch gekennzeichnet, dass** es außerdem einen Speicher des Typs ROM umfasst, der derart verwendet oder programmiert wird, dass er das Stapeln neuer Informationen erlaubt, ohne die alten löschen zu können.

8. Verwendung des elektronischen Datenmediums (2, 21), das in einem Gehäuse nach einem der Ansprüche 1 bis 7 enthalten ist, zum Speichern der technischen Pläne oder Informationen, die die technische Installation beschreiben, die den Schaltschrank, in dem das Gehäuse installiert ist, betrifft.

9. Verwendung nach Anspruch 8 in einer technischen Anlage, die sich in Wohnräumen, Eigenheimen, Wohnungen, Industrieräumen, Geschäftsräumen, Krankenhäusern, Lagern, technischen Räumen, Informatiksälen, öffentlich zugänglichen Räumen, Gebäuden mit großer Höhe, Werken, Baustellen-Steuerkasten, Zügen, Flugzeugen, Schiffen, fahrbaren Generatorsätzen, Fahrzeugen und militärischen Vorrichtungen, Personenkraftwagen, Nutzfahrzeugen, Posten für Verkehrsampeln, Straßenverkehrs-Signalleuchtsäulen, Infostationen, Stundenstempeln oder Verkaufsautomaten befinden.

10. Verfahren zur Aktualisierung technischer Daten, die die technische Installation bezüglich eines Schaltschranks, in dem ein Gehäuse nach einem der Ansprüche 1 bis 6 installiert ist, beschreiben, wobei das Verfahren die folgenden Schritte umfasst:
(i) man öffnet das Mittel zum Verschließen (3),
(ii) man schließt einen ersten Stecker (8) eines Kabels (9), das durch einen zweiten Stecker (10) mit einem Computer oder einem anderen Rechennetzwerk verbunden ist oder zu verbinden ist, an dem Steckverbinder (7) des USB-Sticks (21) an,
(iii) man überträgt Informationen des Computers oder des Rechennetzwerks zu dem USB-Stick (41) und/oder man überträgt Informationen von dem USB-Stick (41) zu dem Computer oder zu dem Rechennetzwerk,
(iv) man steckt den ersten Stecker (8) des Kabels (9) von dem Steckverbinder (7) des USB-Sticks (21) ab,
(v) man schließt das Mittel zum Verschließen (3) wieder.

11. Verfahren nach Anspruch 10, wobei man vor dem Transfer von Informationen zwischen dem beschreibbaren Medium (2) und dem Computer oder dem Rechennetzwerk mindestens ein Passwort eingibt.

## Claims

1. Casing (1) for storing technical information by a user, intended to be mounted in a service cabinet, and in particular intended to be attached to a metal rail (6), said casing comprising a front opening and a closing means (3) making it possible to close said front opening, and said casing (1) further comprising attachment means (5) making it possible to attach said casing (1) in said service cabinet, and advantageously on said metal rail (6), and said casing (1) being **characterised in that** it further comprises
(a) at least one antimagnetic and/or antistatic protection means (4), and
(b) a re-writable medium (2, 21) for storing computer data, being removable or, preferably, fixed, and being protected by said antimagnetic and/or antistatic protection means (4) as well as by said closing means (3), and said re-writable medium for storing computer data (2) being a memory of the USB key type (21) comprising a USB socket (7),
and said USB key (21) being attached in the casing (1) or in its closing means (3), in such a way that its USB socket (7) is accessible after opening of said closing means (3), in such a way as to be able to connect a cable on said socket (7).

2. Casing (1) according to claim 1, wherein said closing means (3) is a cover or a lid.

3. Casing (1) according to claim 1 or 2, **characterised in that** it comprises in addition a means of remote transmission able to transmit data from the re-writable medium (2, 21) to a user, and/or an appropriate connector for connection to a computer network.

4. Casing (1) according to any of claims 1 to 3, **characterised in that** the antimagnetic and/or antistatic protection means (4) is chosen from the group comprising:
- conductive coatings, applied to at least one portion of the external or internal surface, or to both at the same time of said casing,
- a metal casing,
- a plastic casing coated with a conductive coating,
- at least one metal wall,
- a Faraday cage made of wire and/or metal wire mesh,
- a glue or paste loaded with conductive particles that surround at least partially said computer medium.

5. Casing (1) according to any one of claims 1 to 4, **characterised in that** it is a casing containing a device selected from the group comprising: a circuit-breaker, a fuse-holder, a disconnector, a switch, a switch-disconnector, a differential switch, a contactor, a day/night contactor, a current circuit-breaker, a circuit-breaker switch, a circuit-breaker disconnect switch, a differential circuit-breaker, a remote-control switch, a relay, an automat, a variator, a start and/or end of travel contact, a timer, a lighting system, a clock, a timed control systems, a lighted indicator, a pushbutton, a simple or multiple-position switch.

6. Casing (1) according to any one of claims 1 to 5, **characterised in that** it comprises in addition a keyboard (33) allowing a password to be entered, and optionally one or several means of display (32, 34).

7. Casing (1) according to any one of claims 1 to 6, **characterised in that** it comprises in addition a memory of the ROM type, used or programmed in such a way as to allow for the stacking of new information, without being able to erase the old information.

8. Use of said computer medium (2, 21) contained in a casing according to any of claims 1 to 7 for storing plans or technical information describing the technical installation concerning the service cabinet wherein said casing is installed.

9. Utilisation according to claim 8 in a service facility located in the premises of an accommodation, individual homes, flats, industrial premises, commercial premises, hospitals, warehouses, technical premises, computer rooms, establishments that receive the public, high-rise buildings, factories, construction site electrical boxes, trains, aircraft, boats, mobile power generators, agricultural motorised vehicles, military vehicles and devices, passenger vehicles, utility vehicles, sign posts, road signage bollards, traffic signalisation poles, information terminals, parking meters or sales machines.

10. Method for updating technical information describing the technical installation concerning a service cabinet wherein is installed a casing according to any one of claims 1 to 6, said method comprising the following steps:
(i) said closing means (3) is opened,
(ii) a first socket (8) of a cable (9) connected or to be connected by a second socket (10) to a computer or a computer network is connected to the socket (7) of said USB key (21),
(iii) information is transferred from the computer or from the computer network to said USB key (21) and/or information is transferred from said USB key (21) to said computer or to said computer network,
(iv) said first socket (8) of the cable (9) is disconnected from the socket (7) of said USB key (21),
(v) said closing means (3) is closed.

11. Method according to claim 10, wherein, before the transfer of information between the writable medium (2) and the computer or the computer network, at least one password is entered.
